# EUROPEAN PATENT APPLICATION

(11) **EP 1 301 061 A2**
(43) Date of publication of application: **09.04.2003**
(21) Application number: 02253646.0
(22) Date of filing: 23.05.2002
(51) Int. Cl.: H05K 1/02, H04B 10/04, H04B 10/06, H04B 10/24, H01S 5/02, G02B 6/42, H01L 31/00, H05B 33/00

(54) **Flexible electrical interconnect for optical fibre transceivers**

(30) Priority: 29.09.2001 GB 0123475
(71) Applicant: Agilent Technologies, Inc. - a Delaware corporation -, Palo Alto, CA 94303-0870 (US)
(72) Inventor: Date, Andrew Philip Govan, Ipswich, Suffolk IP1 3SP (GB); Bothwell, Andrew, Ipswich, Suffolk (GB); Bendelli, Giampaolo, Fraz. Milanere, Almese (TO) (IT)
(74) Representative: Coker, David Graeme

(57) **Abstract**

The present invention provides an optoelectronic module comprising an optical subassembly (1) and an electrical subassembly (3) each having a plurality of electrical connection points and ground plane connection points. The optical and electrical subassemblies are connected by a flexible circuit (2) comprising transmission lines (11,12) disposed on a substrate having a groundplane (6). The connection is such that electrical connection of the groundplanes is established. The optical and electrical subassemblies are preferably multi-layered structures.

## Description

Data communication systems are increasing in transmission speed such that conventional methods of interconnecting the electronic components within such a system are ceasing to achieve the required performance. This is especially true in fibre optic transceivers where large volumes of data may be aggregated up into a serial stream of data at very high speed which is then used to drive a light source, e.g. laser. "Wiring" in the conventional sense does not offer a reliable, manufacturable interconnection with sufficient electrical performance. A further difficulty is presented in some optical fibre transceivers where the optical component of the transceiver may vary in physical length in order to provide optical alignment. This results in a varying distance between the optical components and electrical components of the transceiver.

Existing solutions to the parametric performance issue have used coaxial connections onto optical assemblies. The are bulky and do not suit the industry need for smaller transceivers. Coaxial connections can also be expensive, difficult to miniaturize and may not be mechanically flexible. Another existing interconnect method from electrical to optical assemblies uses brazed copper leads to provide the connection. Such leads can achieve adequate electrical performance but only if the distance between electrical and optical assemblies can be controlled.

Thus it is an object of the present invention to overcome or at least mitigate the above mentioned technical problems.

According to the present invention there is provided an optoelectronic module comprising an optical subassembly and an electrical subassembly each having a plurality of electrical connection points and ground plane connection points, characterized in that said optical and electrical subassemblies are connected by a flexible circuit, said flexible circuit comprising transmission lines disposed on a substrate having a groundplane, said connection being such that electrical connection of said groundplanes is established.

The solution according to the present invention and described herein provides an electrical connection with good parametric performance up to and beyond 10GHz. The solution also offers a means to accommodate variations in the length of optical assemblies and therefore the distance between optical and electrical assemblies.

This is achieved by the use of a flexible circuit. Flexible circuits in themselves are know but their evolution into a component to solve the problems described above is novel and inventive.

While the principle advantages and features of the invention have been described above, a greater understanding and appreciation of the invention may be obtained by referring to the drawings and detailed description of a preferred embodiment, presented by way of example only, in which:
FIGURE 1 shows the optical subassembly,
FIGURE 2 shows the optical and electrical subassemblies connected by the flexible circuit,
FIGURE 3 is a cross sectional view of the flexible circuit, and
FIGURE 4 is a cross sectional view of the optoelectronic module according to the present invention.

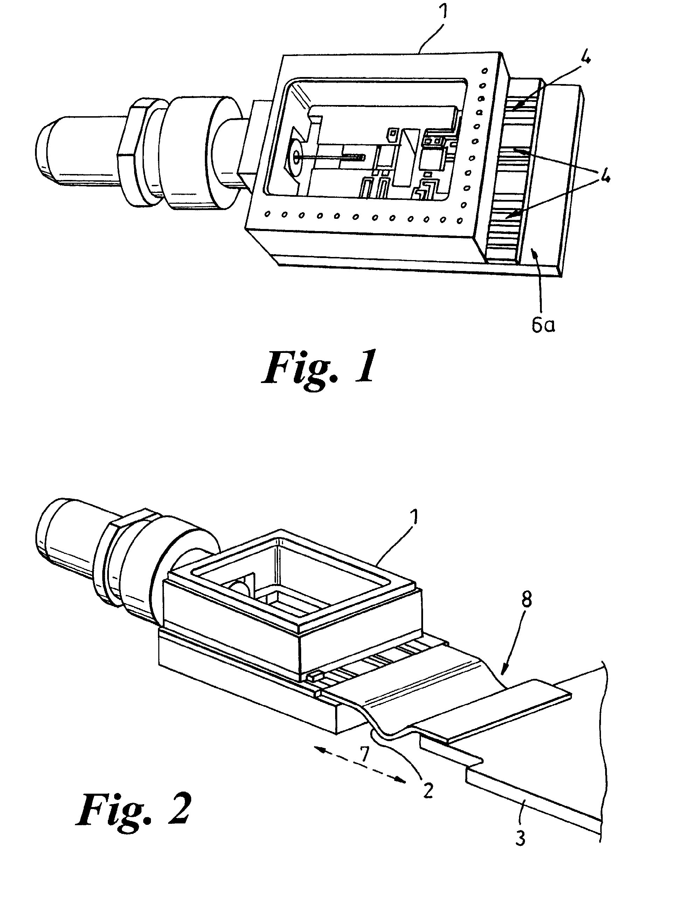

In the present invention as shown in figures 1 and 2, the flexible circuit 2 is disposed between an optical subassembly 1 and physically separate electrical subassembly 3 thus establishing electrical connection between electrical connection points 4 on the optical subassembly and the electrical subassembly.

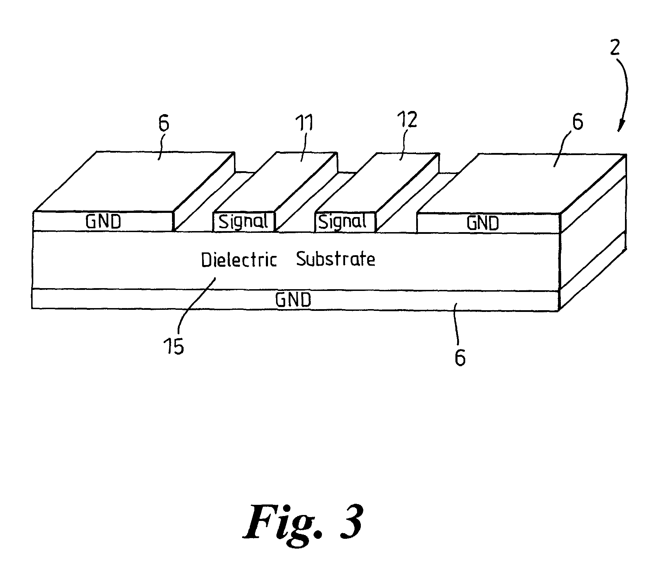

In a future embodiment of the present invention and as shown in figure 3, controlled impedance transmission lines essential for the transmission of high speed signals are incorporated into the flexible circuit 2. These transmission lines are a continuation of similar transmission lines on both the electrical subassembly 3 and the optical subassembly 1. A coplanar waveguide structure with groundplane 6 is the chosen transmission line type. As best seen in figure 2, the flexible circuit is deformed either during the transceiver assembly process or by pre-forming so that it bends 8 (like a caterpillar) to accommodate the differing optical-electrical subassembly separation 7

The transmission lines on the flex are designed so that they support signal transmission over the full range of expected flex curvature. At the optical assembly end of the flex the transmission lines join the optical assembly with minimum electrical discontinuity. Careful selection of the dielectric constant of the flexible circuit minimizes electrical reflections across the interface.

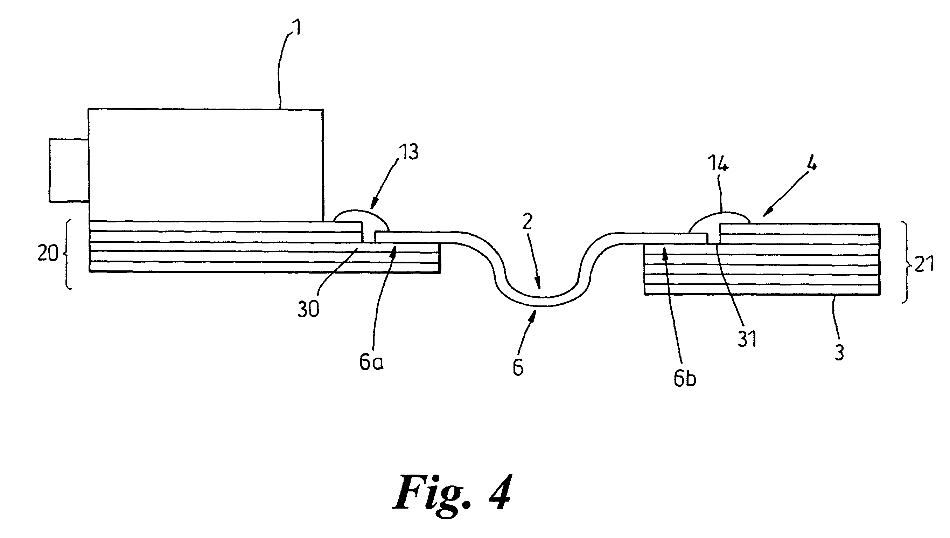

In yet a further embodiment of the present invention and as shown in figure 4, the mechanical attachment of the flexible circuit 2 to the optical subassembly 1 and electrical subassembly 3 is achieved using electrically conductive glue. This results not only in mechanical fixing but also a continuous electrical connection of the groundplanes 6a, 6, and 6b on the optical subassembly, the flexible circuit, and the electrical subassembly respectively. Connection of the signal carrying traces 11, 12 on the top side of the flexible circuit 2 is then achieved using gold ribbon or gold wire bonds 13, 14. The uninterrupted groundplane connection is key to the performance of the electrical and optical subassembly interconnection. The use of multilayer construction 20, 21 of both the optical and electrical subassemblies respectively, enables the uninterrupted groundplane connection to be achieved.

The multilayered subassemblies are preferable made of several layers of printed circuit boards. Alternatively, multiple layer of ceramic material can be used.

Preferable, step features 30, 31 are included in the multilayered subassemblies to facilitates connection of the flexible circuit to the subassemblies. The step features may be double step features.

The present invention as described above and shown in figures 1-4 advantageously offers both electrical and mechanical benefits to fibre optic transceivers by ensuring good high frequency signal transmission and absorbing mechanical tolerances.

Furthermore, the joining technique of the present invention provides for an uninterrupted low inductance groundplane.

It is not intended that the present invention be limited to the above embodiments and other modifications and variations are envisaged within the scope of the claims.

## Claims

1. An optoelectronic module comprising an optical subassembly (1) and an electrical subassembly (3) each having a plurality of electrical connection points (4) and ground plane connection points (6a, 6b), **characterized in that** said optical and electrical subassemblies are connected by a flexible circuit (2), said flexible circuit comprising transmission lines (11,12) disposed on a substrate (15) having a groundplane (6), said connection being such that electrical connection of said groundplanes is established.

2. A module as claimed in Claim 2, wherein said flexible circuit is connected to said optical and electrical subassemblies with electrically conductive glue.

3. A module as claimed in Claim 3, wherein said transmission lines (11, 12) are electrically connected to said optical and electrical subassemblies with wire bonds (13, 14).

4. A module as claimed in any preceding Claim, wherein said optical and/or electrical subassemblies are multi-layered structures (20, 21).

5. A module as claimed in Claim 4, wherein said multilayer optical and/or electrical subassemblies (20, 21) include a step (30, 31) proximate said ground plane connection points (6a, 6b).

6. A module as claimed in Claim 5, wherein said step (30, 31) is a double step.

7. A module as claimed in any preceding Claims, wherein said module is a transmitter.

8. A module as claimed in Claims 1-5, wherein said module is a receiver.

9. A module as claimed in Claims 1-5, wherein said module is a transceiver.

10. A module as claimed in any preceding Claim, wherein said transmission lines are capable of transmitting signals of at least 10 Giga Hertz.
